# EUROPEAN PATENT SPECIFICATION

(11) **EP 1 789 205 B1**
(45) Date of publication and mention of the grant of the patent: **07.04.2010**
(21) Application number: 05759857.5
(22) Date of filing: 08.07.2005
(51) Int. Cl.: B05D 1/30, B41M 3/00

(54) **METHOD OF FORMING UNIFORM LINES ON A SUBSTRATE**
VERFAHREN ZUR BILDUNG VON EINHEITLICHEN LINIEN AUF EINEM SUBSTRAT
PROCEDE DE FORMATION DE LIGNES UNIFORMES SUR UN SUBSTRAT

(30) Priority: 23.07.2004 GB 0416434
(43) Date of publication of application: 30.05.2007
(73) Proprietor: Eastman Kodak Company, Rochester NY 14650-2201 (US)
(72) Inventor: CLARKE, Andrew, Berkhamstead, Hertfordshire HP4 3DG (GB)
(74) Representative: Weber, Etienne Nicolas
(86) International application number: PCT/GB2005/002703
(87) International publication number: WO 2006/008454

(56) References cited:
- US-A- 5 674 592
- DUINEVELD P C: "THE STABILITY OF INK-JET PRINTED LINES OF LIQUID WITH ZERO RECEDING CONTACT ANGLE ON A HOMOGENEOUS SUBSTRATE" JOURNAL OF FLUID MECHANICS, CAMBRIDGE UNIVERSITY PRESS, CAMBRIDGE, GB, vol. 477, 25 February 2003 (2003-02-25), pages 175-200, XP008041681 ISSN: 0022-1120 cited in the application

## Description

### FIELD OF THE INVENTION

The invention relates to the production of a track or line on a substrate, in particular to the production of a straight track having parallel sides.

### BACKGROUND OF THE INVENTION

With consumer printer market growth, inkjet printing has become a broadly applicable technology for supplying small quantities of liquid to a surface in an image-wise way. Both drop-on-demand and continuous drop devices have been conceived and built. Whilst the primary development of inkjet printing has been for aqueous based systems with some applications of solvent based systems, the underlying technology is being applied much more broadly. One such application is the printing of conductive or semi-conductive or emissive or other tracks on a surface. Key requirements of such tracks are that they are continuous and have parallel sides.

WO 03/034130 discloses a method of corralling a liquid line to ensure the width dimension is constant and the liquid does not flow excessively. This method has the disadvantage of requiring two additional lines of liquid to be formed in order to corral the material of interest. Moreover the two additional lines must themselves be free of imperfections in their width.

WO 02/059985 discloses a similar method which uses a hydrophobic pattern to limit the spread of the liquid to be printed. Again two additional lines must be printed and those lines themselves must be free of imperfections.

An alternative to limiting the spread of the liquid being printed is to solidify the liquid before inhomogeneities can form. WO 01/54903 discloses a method wherein the substrate being printed on is maintained at a different temperature to the head and the printing liquid is thermally cured. EP 1163552B1(equivalent to WO 01/11426) and GB2352688 each disclose a method where the droplets are exposed to UV light as they exit and travel to the substrate. The material is chosen such that it solidifies before it can spread inhomogeneously. In each of these methods the desire to have straight, parallel-sided lines of an active material is recognised.

In addition to the prior patent art, there are three pertinent journal articles: Duineveld, P.C. J. Fluid Mech. (2003), vol. 477, pp. 175-200; Schiaffino, S. & Sonin, A. J. Fluid Mech. (1997), vol. 343, pp. 95-110; Davis, S.H..J. Fluid Mech. (1980), vol. 98, pp. 225-242. In each case a model of liquid flow in a rivulet on a surface is calculated for very restrictive classes of surface wettability. In none of these articles do the authors indicate or disclose the modification required for either a volatile liquid or an absorbative surface.

### PROBLEM TO BE SOLVED BY THE INVENTION

At the present time there is no way to ensure a printed line has parallel sides without using an adjunct 'corralling' wall that has previously been printed.

A straight liquid rivulet resting on a solid surface is intrinsically unstable (Davies, Schiaffino & Sonnin) within certain parameter ranges defined by the wetting properties of the substrate. Furthermore, the act of continuously creating a rivulet by successive drop placement at the nose of the growing rivulet causes a liquid flow creating an additional instability. Both these mechanisms lead to printed lines with non-parallel sides. It is the purpose of this invention to specify material properties and printing conditions that allow the instabilities to be avoided and therefore allows the successful printing of parallel-sided lines using inkjet methods.

### SUMMARY OF THE INVENTION

The present invention recognises that by suitably controlling the wetting properties of the substrate against the liquid and by suitably controlling the printing parameters, a straight parallel edged line is achievable with no further equipment or complexity.

According to the present invention there is provided a method of creating lines on a substrate using droplets of liquid, said method comprising the steps of;
a) ensuring the receding contact angle of the liquid composition on the surface of the substrate is less than 10°;
b) ensuring the drop spread S, defined by r/R, is greater than the drop spread So, defined by r₀/R where;
   r (m) is the base radius of a sessile drop on the surface measured about τs after first touching the surface where τ=5R/u
   u (m/s) is the impact velocity of the drop;
   R(m) is the radius of the droplet just before impact with the surface; and
   r₀ (m) is the base radius of the sessile drop on the surface when the contact angle is the static advancing contact angle;
c) ensuring the contact angle of the rivulet formed by the drops is smaller than the advancing contact angle at all times greater than τ; and
*d)* placing successive drops at a centre to centre distance, measured over the surface of the substrate, greater than zero and less than the drop diameter, whereby a printed line is created with parallel edges.

The receding contact angle of the liquid composition on the surface is preferably less than 5°.

### ADVANTAGEOUS EFFECT OF THE INVENTION

The method of the present invention avoids bridging of adjacent lines created by inkjet printers. In using inkjet methods to create a conventional circuit pattern, either in a mask or using an active material, such as a material having conductive, semi conductive or dielectric properties, the invention provides for straight parallel sided lines to be created without adjunct hardware or additional steps.

The invention also provides for creating display line elements with straight parallel sided lines using inkjet methods without adjunct hardware or additional steps.

### BRIEF DESCRIPTION OF THE DRAWING

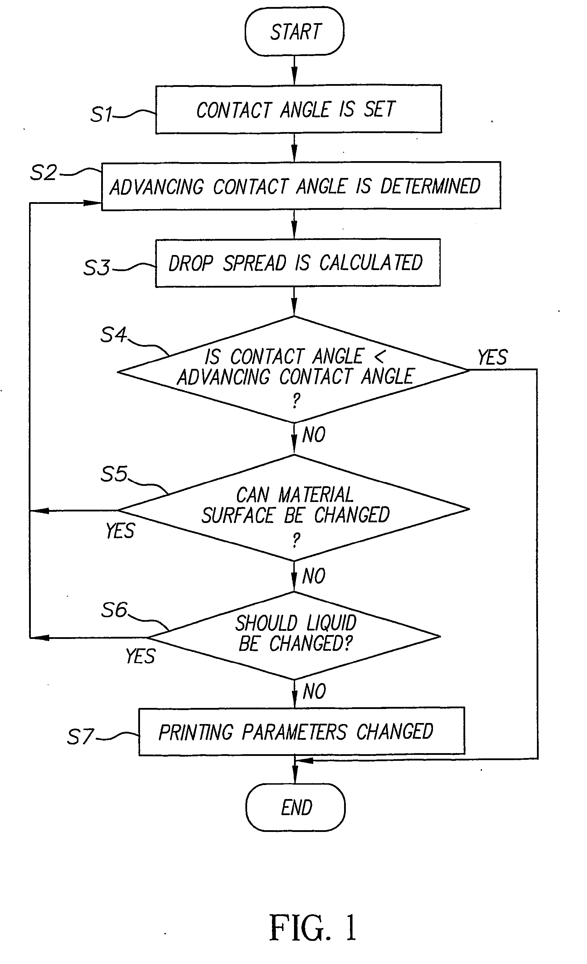

Figure 1 is a flow chart illustrating the steps taken in creating a parallel edged line in accordance with the invention.

### DETAILED DESCRIPTION OF THE INVENTION

There are a number of parameters which influence the instabilities which lead to the creation of non uniform lines. These include parameters relating to the liquid being used to print the lines, the substrate being printed on and the interactions between the two or components of the two. The parameters are as follows;
The static surface tension of the liquid;
Liquid dynamic surface tension changes that occur between about 1ms and 25ms from drop formation;
The static advancing contact angle;
The dynamic advancing contact angle;
The static receding contact angle;
The droplet size - this is defined by the inkjet head used;
The droplet impact velocity - this is defined by the inkjet head used;
The viscosity of the liquid - this is limited by the inkjet head used;
The rate of removal of liquid from the surface (either through porous imbibition or diffusive absorption or evaporation) or rate of solidification;
The rate of drop arrival;
The spacing between successive droplets on the surface of the substrate;
The roughness of the substrate.

Instability can be avoided if the local contact angle is always less than the advancing angle, and the receding angle is always as close to zero as possible. However, in any printing situation, a dynamic balance of the twelve parameters above determines the local contact angle. Thus, it is in fact necessary to specify the range of the twelve parameters to ensure that the contact angle is lower than the advancing angle at all times.

It has been shown, in Davis, and later in Schiaffino and Sonin, that for a pinned wetting line, i.e. where the contact angle is free to take any value without movement of the wetting line position, a rivulet is intrinsically stable provided the contact angle is kept below 90°. For a free wetting line, i.e. where the contact angle is fixed at the equilibrium value and the wetting line is able to.move freely, a rivulet is unstable irrespective of the value of the contact angle. In general, a surface together with a liquid will display hysteresis; that is, for a particular location of the wetting line there are a range of contact angles where the wetting line will not move. The analyses of Davis and later Schiaffino and Sonnin do not address the general case. Duineveld develops a flow model for a further specific case of zero receding contact angle, i.e. where a wetting line can advance across a surface, but cannot retract. In none of the papers, do the authors consider the effect of removal of liquid from the surface by absorbtion, evaporation, or any other means. Neither do they consider progressive solidification on the surface.

A further reason that printed lines may be non-uniform is that dynamical Marangoni forces can drive liquid flows on the surface. These forces arise through surface tension gradients, which in turn arise because of differing surface ages along the rivulet. As droplets are printed, they have essentially zero age and have the bulk liquid surface tension. As time progresses, further drops are added to the rivulet whilst the local surface ages. Hence the surface tension drops, causing a gradient of surface tension towards the front of the rivulet, driving liquid in this direction.

The method of the present invention reduces to choosing material parameters and printing parameters that lead to the contact angle being below the advancing angle at all times and therefore to the suppression of the instability modes. Suppression of these modes allows the printing of liquid rivulet lines that have uniform cross-section.

There are a number of conditions which are necessary or preferable for the suppression of the instability modes according to the present invention. These are set out below.

To achieve liquid rivulet lines with uniform cross section the surface of the substrate being printed on should have as low a receding contact angle with the liquid as possible, preferably zero. This can be achieved by control of the solid surface chemistry using, for example corona discharge, and/or addition of species within the ink that absorb on the solid surface. It can also be achieved by charging the solid surface using the spreading liquid as one electrode. In each case, a few strongly interacting sites will ensure the wetting line cannot recede.

After impact of the droplet, the contact angle should reach its static advancing angle as quickly as possible. This can be achieved by making the surface rough and/or have on average a weak interaction with the substrate, together with the droplet having sufficient kinetic energy on impact. The droplet will then spread due to the impact inertia and provided the inertia is high enough it will spread to a radius beyond that commensurate with the static advancing contact angle. Then, given the receding contact angle is close to zero, the wetting line can neither advance nor recede because the resulting contact angle is less than the advancing contact angle but greater than the receding contact angle.

The advancing contact angle should be as low as possible consistent with the conditions set out in the paragraph above. The lower the contact angle the longer it will take to reach equilibrium.

Surface tension gradients should be minimised. This can be achieved by either removing surface-active species from the liquid, or by ensuring the liquid has a large fraction of low surface tension species. In the latter case the surface tension of the liquid reaches its equilibrium value sufficiently rapidly that surface tension gradients are avoided.

The rate of transport of liquid away from the impact zone of the droplets should be greater than the arrival rate of liquid. The rate of transport away from the impact zone is determined by the contact angle, the viscosity, the evaporation rate and the absorption rate. The droplet size, the spacing between successive droplets and the frequency of their arrival, determines the rate of liquid arrival per unit area.

Drops should not be printed on top of rivulets that are still liquid, unless the contact angle will remain below the advancing contact angle.

Although it is necessary for the substrate surface to have as low a receding contact angle with the liquid as possible this is not sufficient in itself to avoid instability. The rivulet will necessarily be stable if this condition is combined with the contact angle being smaller than the advancing contact angle at all times.

By having the advancing contact angle as low as possible consistent with the above any existing residual instability is minimised and instability growth reduced. This lengthens the growth time and provides time for evaporation absorption or curing to fix the liquid in position.

Minimising the surface tensions is not an essential feature of the invention but needs to be considered in controlling contact angles and in order to minimise unwanted Marangoni flows.

For particular printing parameters the difference in the rate of transport of liquid away from the impact zone of the droplets to the arrival rate of the liquid should be maximised. This should however be consistent with the receding contact angle being as low as possible and the contact angle being less than the advancing contact angle at all times.

Figure 1 is a flow chart illustrating the steps to be taken when creating a parallel edged line.

In step S1 the receding contact angle is set to less than 10°, preferably less than 5°. This may be achieved, for example, by forming a low density of high energy sites on the surface of the material via corona discharge treatment.

In step S2 the advancing contact angle is determined. This may be done, for example, by using the DAT or PISA instruments. The DAT1100 is manufactured by Fibro System AB of Hagersten, Sweden. Information regarding the PISA instrument can be found in Langmuir 18,8 (2002) 2980.

In step S3 the drop spread S is calculated. The drop spread is defined by r/R where;
r is the base radius of a sessile drop on the surface measured about τs after first touching the surface where τ=5R/u, u is the impact velocity of the drop and R is the radius of the droplet just before impact with the surface.

All units are standard SI units.

The Weber number may also be calculated in step S3. It is possible to determine the drop spread S from the Weber number but this is not a preferred method. The Weber number We is defined by ρuR/γ, where ρ is the liquid density, u is the impact velocity of the drop, R is the radius of the droplet just before impact with the surface and γ is the liquid surface tension.

In step S4 it is determined whether or not the contact angle associated with the drop spread S is less than the advancing contact angle. If yes, the liquid can be printed onto the material or substrate. If no, the process continues to step S5.

In step S5 it is determined whether or not the surface of the material on which the lines are to be printed can be changed. If yes, the solid liquid interfacial energy is reduced. This could be effected, for example, by changing the composition of the substrate or changing the surface chemistry by surface treatment. The surface could be changed by increasing the roughness thereof. Once this has been done the process returns to step S2.

If the surface is not to be changed the process continues to step S6 where it is determined whether or not the liquid should be changed.

If the answer is yes the liquid-vapour surface tension is reduced or the liquid viscosity is reduced. Alternatively a component can be added which adsorbs at the solid-liquid interface to reduce the solid-liquid interfacial energy. Once one of these steps has been taken the process returns to step S2.

If the liquid is not to be changed then the process continues to step 7. In step 7 the printing parameters are changed. The printing may be faster or less liquid may be printed. Alternatively the printing may be done sufficiently slowly that the liquid on the surface is either absorbed, evaporated or solidified such that no further flow can occur.

The method of the invention is particularly relevant to the creation of masks for printed circuit board manufacture or for printing plates, or the direct creation of conductive tracks and electronic circuitry. It is equally applicable to the field of inkjet printing generally where it is wished to have a straight parallel line which does not spread to adjacent printed lines. The invention could be used for the creation of lenticular lens, the creation of stereo images, masks in coating technologies, micro "bar codes". It will be understood that these are examples only and the invention has use in any application where there is creation of lines using liquid in a drop wise fashion.

The invention has been described in detail with reference to preferred embodiments thereof. It will be understood by those skilled in the art that variations and modifications can be effected within the scope of the invention.

## Claims

1. A method of creating lines on a substrate using droplets of liquid, said method comprising the steps of;
a) ensuring the receding contact angle of the liquid composition on the surface of the substrate is less than 10°;
b) ensuring the drop spread S, defined by r/R, is greater than the drop spread So, defined by r₀/R where;
r (m) is the base radius of a sessile drop on the surface measured about τs after first touching the surface where τ=5R/u
u (m/s) is the impact velocity of the drop;
R(m) is the radius of the droplet just before impact with the surface; and
r₀ (m) is the base radius of the sessile drop on the surface when the contact angle is the static advancing contact angle;
c) ensuring the contact angle of the rivulet formed by the drops is smaller than the advancing contact angle at all times greater than τ; and
d) placing successive drops at a centre to centre distance, measured over the surface of the substrate, greater than zero and less than the drop diameter, whereby a printed line is created with parallel edges.

2. A method as claimed in claim 1 wherein the receding contact angle of the liquid composition on the surface is less than 5°.

3. A method as claimed in claim 1 or 2 wherein the receding contact angle of the liquid composition on the surface is 0°.

4. A method as claimed in claim 1, 2 or 3 wherein the drop spread S is increased by increasing the drop Weber number, the Weber number We being defined by We=ρuR/γ, where ρ is the liquid density, u is the impact velocity of the drop, R is the radius of the droplet just before impact with the surface and γ is the liquid surface tension.

5. A method as claimed in claim 1, 2 or 3 wherein the drop spread S is increased by increasing the roughness of the substrate.

6. A method as claimed in claim 1, 2 or 3 wherein the drop spread S is increased by reducing the average solid-liquid interfacial energy.

7. A method as claimed in claim 1, 2 or 3 wherein the drop spread S is increased by reducing the liquid viscosity.

8. A method as claimed in any preceding claim wherein the contact angle of the rivulet is maintained below the advancing angle by providing the substrate with the ability to absorb the liquid.

9. A method as claimed in claim 8 wherein the contact angle of the rivulet is maintained below the advancing angle by making the substrate porous.

10. A method as claimed in claim 8 wherein the contact angle of the rivulet is maintained below the advancing angle by making the substrate absorb through diffusive processes.

11. A method as claimed in any of claims 1 to 7 wherein the contact angle of the rivulet is maintained below the advancing angle by providing a component of the liquid composition that readily evaporates

12. A method as claimed in any of claims 1 to 7 wherein the contact angle of the rivulet is maintained below the advancing angle by reducing the flow of liquid along the rivulet by increasing the viscosity of the liquid composition.

13. A mask, for use in the manufacture of printed circuit boards or printing plates, formed by the method of claim 1.

14. A mask, for use in coating technologies, formed by the method of claim 1.

15. Conductive tracks, forming part of electronic circuitry formed by the method of claim 1.

16. Circuit components, forming part of electronic circuitry formed by the method of claim 1.

17. Bar codes, for identification, formed by the method of claim 1.

## Patentansprüche

1. Verfahren zum Erzeugen von Linien auf einem Substrat unter Verwendung von Flüssigkeitstropfen, wobei das Verfahren folgende Schritte umfasst:
a) Sicherstellen, dass der Rückzugskontaktwinkel der Flüssigkeitsmischung auf der Oberfläche des Substrats kleiner ist als 10°;
b) Sicherstellen, dass die Tropfenausbreitung S, die durch r/R definiert ist, größer ist als die Tropfenausbreitung S₀, die durch r₀/R definiert ist, wobei
r (m) der Grundradius eines auf der Oberfläche liegenden Tropfens ist, gemessen bei τs, nachdem der Tropfen die Oberfläche erstmals berührt hat, wobei τ=5R/u;
u (m/s) die Auftreffgeschwindigkeit des Tropfens ist;
R (m) der Radius des Tropfens ist, kurz bevor er auf die Oberfläche auftrifft; und
r₀ (m) der Grundradius des auf der Oberfläche liegenden Tropfens ist, wenn der Kontaktwinkel der statische Fortschreitkontaktwinkel ist;
c) Sicherstellen, dass der Kontaktwinkel des durch die Tropfen gebildeten Rinnsals kleiner ist als der Fortschreitkontaktwinkel, der immer größer ist als τ; und
d) Platzieren aufeinanderfolgender Tropfen in einem Mittenabstand, der, gemessen auf der Oberfläche des Substrats, größer als null und kleiner als der Tropfendurchmesser ist,
wodurch eine gedruckte Linie mit parallelen Rändern erzeugt wird.

2. Verfahren nach Anspruch 1, worin der Rückzugskontaktwinkel der Flüssigkeitsmischung auf der Oberfläche kleiner ist als 5°.

3. Verfahren nach Anspruch 1 oder 2, worin der Rückzugskontaktwinkel der Flüssigkeitsmischung auf der Oberfläche 0° beträgt.

4. Verfahren nach Anspruch 1, 2 oder 3, worin die Tropfenausbreitung S vergrößert wird durch Erhöhen der Weber-Zahl des Tropfens, wobei die Weber-Zahl We definiert wird durch We=ρuR/γ, wobei ρ die Flüssigkeitsdichte, u die Auftreffgeschwindigkeit des Tropfens, R der Radius des Tropfens kurz vor seinem Auftreffen auf die Oberfläche und γ die Oberflächenspannung der Flüssigkeit ist.

5. Verfahren nach Anspruch 1, 2 oder 3, worin die Tropfenausbreitung S vergrößert wird durch Erhöhung der Substratrauheit.

6. Verfahren nach Anspruch 1, 2 oder 3, worin die Tropfenausbreitung S vergrößert wird durch Reduzierung der durchschnittlichen Fest-Flüssig-Grenzflächenenergie.

7. Verfahren nach Anspruch 1, 2 oder 3, worin die Tropfenausbreitung S vergrößert wird durch Reduzierung der Flüssigkeitsviskosität.

8. Verfahren nach einem der vorhergehenden Ansprüche, worin der Kontaktwinkel des Rinnsals unterhalb des Fortschreitwinkels gehalten wird durch Versehen des Substrats mit der Fähigkeit, die Flüssigkeit zu absorbieren.

9. Verfahren nach Anspruch 8, worin der Kontaktwinkel des Rinnsals **dadurch** unterhalb des Fortschreitwinkels gehalten wird, dass das Substrat porös gemacht wird.

10. Verfahren nach Anspruch 8, worin der Kontaktwinkel des Rinnsals **dadurch** unterhalb des Fortschreitwinkels gehalten wird, dass das Substrat durch diffusive Prozesse absorbierend wirkt.

11. Verfahren nach einem der Ansprüche 1 bis 7, worin der Kontaktwinkel des Rinnsals **dadurch** unterhalb des Fortschreitwinkels gehalten wird, dass ein Bestandteil der Flüssigkeitsmischung bereitgestellt wird, der leicht verdampft.

12. Verfahren nach einem der Ansprüche 1 bis 7, worin der Kontaktwinkel des Rinnsals **dadurch** unterhalb des Fortschreitwinkels gehalten wird, dass die Flüssigkeitsströmung entlang des Rinnsals durch Erhöhen der Viskosität der Flüssigkeitsmischung reduziert wird.

13. Maske zur Verwendung bei der Herstellung von Leiterplatten oder Druckplatten, die mittels des Verfahrens gemäß Anspruch 1 hergestellt werden.

14. Maske zur Verwendung in der Beschichtungstechnik, die mittels des Verfahrens gemäß Anspruch 1 hergestellt wird.

15. Leiterbahnen, die Teil elektronischer Schaltkreise sind und mittels des Verfahrens gemäß Anspruch 1 hergestellt werden.

16. Schaltkreiskomponenten, die Teil elektronischer Schaltkreise sind und mittels des Verfahrens gemäß Anspruch 1 hergestellt werden.

17. Strichcodes zur Identifikation, die mittels des Verfahrens gemäß Anspruch 1 hergestellt werden.

## Revendications

1. Procédé de création de lignes sur un substrat en utilisant des gouttelettes de liquide, ledit procédé comprenant les étapes consistant à :
a) garantir que l'angle de contact sortant de la composition liquide sur la surface du substrat est inférieur à 10°,
b) garantir que l'étalement de la goutte S, défini par r/R, est supérieur à l'étalement de la goutte S₀, défini par r₀/R où,
r (m) est le rayon de base d'une goutte sessile sur la surface mesuré environ τs après le premier contact avec la surface où τ = 5 R/u
u (m/s) est la vitesse d'impact de la goutte,
R (m) est le rayon de la gouttelette juste avant impact avec la surface, et
r₀ (m) est le rayon de base de la goutte sessile sur la surface lorsque l'angle de contact est l'angle de contact rentrant statique,
c) garantir que l'angle de contact du ruisselet formé par les gouttes est inférieur à l'angle de contact rentrant à tous les temps supérieurs à τ, et
d) positionner les gouttes successives à une distance de centre à centre, mesurée au-dessus de la surface du substrat, supérieure à zéro et inférieure au diamètre des gouttes,
grâce à quoi une ligne imprimée est créée avec des bords parallèles.

2. Procédé selon la revendication 1, dans lequel l'angle de contact sortant de la composition liquide sur la surface est inférieur à 5°.

3. Procédé selon la revendication 1 ou 2, dans lequel l'angle de contact sortant de la composition liquide sur la surface est de 0°.

4. Procédé selon la revendication 1, 2 ou 3, dans lequel l'étalement de la goutte S est augmenté en augmentant le nombre de Weber de la goutte, le nombre de Weber We étant défini par We = ρuR/γ, où ρ est la masse volumique du liquide, u est la vitesse d'impact de la goutte, R est le rayon de la gouttelette juste avant l'impact avec la surface et γ est la tension superficielle du liquide.

5. Procédé selon la revendication 1, 2 ou 3, dans lequel l'étalement de la goutte S est augmenté en augmentant la rugosité du substrat.

6. Procédé selon la revendication 1, 2 ou 3, dans lequel l'étalement de la goutte S est augmenté en diminuant l'énergie interfaciale solide - liquide moyenne.

7. Procédé selon la revendication 1, 2 ou 3, dans lequel l'étalement de la goutte S est augmenté en diminuant la viscosité du liquide.

8. Procédé selon l'une quelconque des revendications précédentes, dans lequel l'angle de contact du ruisselet est maintenu inférieur à l'angle rentrant en dotant le substrat de la capacité à absorber le liquide.

9. Procédé selon la revendication 8, dans lequel l'angle de contact du ruisselet est maintenu inférieur à l'angle rentrant en rendant le substrat poreux.

10. Procédé selon la revendication 8, dans lequel l'angle de contact du ruisselet est maintenu inférieur à l'angle rentrant en rendant le substrat absorbant grâce à des traitements de diffusion.

11. Procédé selon l'une quelconque des revendications 1 à 7, dans lequel l'angle de contact du ruisselet est maintenu inférieur à l'angle rentrant en fournissant un composant de la composition liquide qui s'évapore facilement.

12. Procédé selon l'une quelconque des revendications 1 à 7, dans lequel l'angle de contact du ruisselet est maintenu inférieur à l'angle rentrant en diminuant l'écoulement de liquide le long du ruisselet en augmentant la viscosité de la composition liquide.

13. Masque, destiné à être utilisé pour la fabrication de cartes à circuits imprimés ou de plaques d'impression, formé par le procédé de la revendication 1.

14. Masque, destiné à être utilisé dans des technologies de revêtement, formé par le procédé de la revendication 1.

15. Pistes conductrices, faisant partie de circuits électroniques formés par le procédé de la revendication 1.

16. Composants de circuits, faisant partie de circuits électroniques formés par le procédé de la revendication 1.

17. Codes à barres, pour une identification, formés par le procédé de la revendication 1.
